# EUROPEAN PATENT APPLICATION

(11) **EP 4 838 296 A1**
(43) Date of publication of application: **11.11.2026**
(21) Application number: 25382458.5
(22) Date of filing: 06.05.2025
(51) Int. Cl.: G02F 1/365, G06N 10/40

(54) **QUANTUM SENSING AND METROLOGY WITH FREE ELECTRONS**

(71) Applicant: Fundació Institut de Ciències Fotòniques, 08860 Castelldefels (Barcelona) (ES); Institució Catalana De Recerca I Estudis Avançats (ICREA), 08010 Barcelona (ES)
(72) Inventor: Garcia de Abajo, Javier, 08860 Castelldefels (Barcelona) (ES); Velasco, Cruz Ignacio, 08860 Castelldefels (Barcelona) (ES)
(74) Representative: Grünecker Patent- und Rechtsanwälte PartG mbB

(57) **Abstract**

A system for quantum sensing and metrology with free electrons, including one or more subsystems, each subsystem comprising: an electron source configured to provide an incident beam of electrons; at least one optical waveguide and at least one corresponding gate element of the at least one optical waveguide, respectively; the at least one optical waveguide exhibiting respective electromagnetic modes confined within the waveguide; one or more electron beam collimation and focusing elements configured to collimate and focus the beam of electrons and to control a trajectory of the collimated and focused beam of electrons such that a distance between at least parts of the trajectory of the electron beam and the waveguide is smaller than a penetration length of the confined electromagnetic modes of the waveguide into the vacuum; wherein the at least one gate element is configured to generate an electric field according to a predetermined potential difference between the at least one gate element and the at least one optical waveguide the potential difference being between the at least one gate element and the surface of the corresponding at least one optical waveguide, and to control a distance between the trajectory of the electron beam and the at least one optical waveguide as being larger than or equal to a predetermined minimum distance; wherein the predetermined minimum distance is smaller than the penetration length of the confined electromagnetic modes of the waveguide into the vacuum; wherein the at least one optical waveguide is configured to interact with the electron beam in that the at least one optical waveguide is configured generate a plurality of photons when the beam of electrons travels along the parts of the trajectory of the beam of electrons being closer to the waveguide than the penetration length of the confined electromagnetic modes of the waveguide into the vacuum, wherein the plurality of photons is to be waveguided within the optical waveguide; at least one electron detector configured to measure an intensity of the beam of electrons after having interacted with the waveguide to detect the plurality of photons waveguided by the waveguide.

## Description

### Field of Invention

The present invention relates to a system and corresponding method for performing quantum sensing and metrology with free electrons.

### Background of the invention

Quantum sensing and metrology encompass a width of techniques that exploit the quantum properties of microscopic systems, such as entanglement and wave-like behavior, to obtain an improved sensitivity and resolution when compared to classical methods. One such area is quantum optics, where the generation and detection of nonclassical states of light have been employed to perform measurements with unmatched sensitivity. For example, squeezed states played a key role in the detection of gravitational waves, where a light interferometer was used to sense modulations of space 10⁻¹⁸ orders of magnitude smaller than the wavelength of the lasers used [1]. Furthermore, more exotic states of light such as the so- called NOON states $\left.\left|NOON\right.\right〉 = \left[\left.\left|N, 0\right.\right〉+\left.\left|0, N\right.\right〉\right] / \sqrt{2}$, a maximally entangled superposition of *N*-photon number states that saturate the Heisenberg uncertainty limit [2] could enable measurements displaying both super resolution and super sensitivity, beating both the diffraction and shot-noise limits respectively. These properties position NOON states as powerful tools in areas such as quantum sensing and metrology [2], quantum lithography [3]. Besides this, NOON states with large photon numbers, i.e. so-called high-NOON states, could also provide insight into the properties of entanglement in the macroscopic regime.

For low photon numbers, *N* ≤ 2 NOON states can be generated by exploiting destructive interference in the outgoing paths of a beam splitter in what is known as the Hong-Ou-Mandel effect [2]. These have been produced in previous works [4] and have even been demonstrated to surpass the shot-noise limit. However, significant improvements to sensing capabilities require high photon numbers, for which the Hong-Ou-Mandel effect does not scale. Due to this, alternative schemes have been devised to try and increase *N* beyond this limit, such as using non-linear operations usually associated with postselection measurements, which were first used to generate N = 3 NOON states [5], or combining quantum and classical light in a beam splitter (BS) to a achieve a NOON state with *N* = 5 [6]. Other methods include utilizing a higher number of modes to generate "NOON-like" states presenting increased sensitivity [7], and performing projective measurements to detect only the NOON-like components of many-photon entangled states [8]. Additionally, NOON states have been demonstrated to increase the sensitivity in other types of systems such as atomic spin-waves [9]. However, a scalable method for the high-rate generation of high-number states has remained elusive.

Free electrons constitute genuine quantum objects with multiple degrees of freedom such as their energy and deflection angle, i.e. resolved through methods such as momentum-defined electron energy loss spectroscopy, and wave-like behavior manifesting through diffraction, interference, and superposition. Moreover, as broadband evanescent field sources, electrons can couple to strongly confined electromagnetic modes in waveguides and cavities [10]. Strong interactions can be obtained by taking advantage of the fact that the coupling probability *P* is proportional to the interaction length *L*, resulting in *P* ≳ 1 for L in the range of hundreds of microns in the optical or near-infrared range [11]. For an electric field in an initial vacuum state, a strong interaction with the electron generates a coherent photon state that is entangled with the electron's energy spectrum, with each energy component representing the energy of the electron after the emission of a given number of photons, a fact that has allowed post-selection over the electron's energy to herald the creation of quantum states of light [12]. We envision utilizing the strong interactions taking place between electron waves and confined modes of light, in the form of waveguided modes or long-lived polaritons with bosonic properties in general, and the generation of entanglement between them as a way to generate and detect quantum states of light with high-photon numbers beyond what can be currently reached with light alone.

In view of the above, it is an object of the present invention to alleviate the above-mentioned problems by providing a system and corresponding method for performing quantum sensing and metrology with free electrons.

In the following, we use the terms "optical waveguide" and waveguide synonymously. We also use the term "quantum free electronics" to denote the use of free electrons to perform quantum measurements, sensing, or metrology.

### Summary

The present invention addresses the above-mentioned problems by providing the following: A first aspect of a system for quantum sensing and metrology with free electrons, including one or more subsystems, each subsystem comprising: an electron source configured to provide an incident beam of electrons; at least one optical waveguide and at least one corresponding gate element of the at least one optical waveguide, respectively; the at least one optical waveguide exhibiting respective electromagnetic modes confined within the waveguide; one or more electron beam collimation and focusing elements configured to collimate and focus the beam of electrons and to control a trajectory of the collimated and focused beam of electrons such that a distance between at least parts of the trajectory of the electron beam and the waveguide is smaller than a penetration length of the confined electromagnetic modes of the waveguide into the vacuum; wherein the at least one gate element is configured to generate an electric field according to a predetermined potential difference between the at least one gate element and the at least one optical waveguide the potential difference being between the at least one gate element and the surface of the corresponding at least one optical waveguide, and to control a distance between the trajectory of the electron beam and the at least one optical waveguide as being larger than or equal to a predetermined minimum distance; wherein the predetermined minimum distance is smaller than the penetration length of the confined electromagnetic modes of the waveguide into the vacuum; wherein the at least one optical waveguide is configured to interact with the electron beam in that the at least one optical waveguide is configured generate a plurality of photons when the beam of electrons travels along the parts of the trajectory of the beam of electrons being closer to the waveguide than the penetration length of the confined electromagnetic modes of the waveguide into the vacuum, wherein the plurality of photons is to be waveguided within the optical waveguide; at least one electron detector configured to measure an intensity of the beam of electrons after having interacted with the waveguide to detect the plurality of photons waveguided by the waveguide.

Throughout the present disclosure, waveguided modes should be understood as modes of the electromagnetic field confined inside a waveguide that can propagate along its axis while radiating a negligible energy into the surrounding medium. Waveguided photons in turn, refer to quantized excitations of the electromagnetic field associated with these confined modes.

Thus, the present disclosure provides having a minimum distance so that the electron does not interact with other non-waveguided modes, such as electron-hole pairs in the material, phonons, etc. Further, the excitation of those modes by the electron destroys quantum coherence in the electron, i.e. which needs to be preserved for quantum sensing and metrology. Here, for example, the strategy of a working with distances of about 50 nm for 200 keV electrons, or similar energy, is an innovative part of the present disclosure.

In other words, the controlled distance between the electron and the waveguide, allows for the generation of photons during interaction in a preselected set of modes, i.e. Those modes for which the penetration length is larger than said distance, that can propagate for long distances with insignificant losses, while minimizing the probability of coupling with modes which present short propagation distances and strong losses and with those corresponding to localized material excitations, for which the penetration length is smaller than said distance. This allows for interactions taking place over distances over several hundred of micrometres, which are intense enough to generate tens of photons in the preselected modes, far beyond what is possible with current technologies.

It should be understood that controlling a distance between the trajectory of the electron beam and the at least one optical waveguide as being larger than or equal to a predetermined minimum distance is to avoid electron coupling to non-waveguided excitations that can damage the coherence of the electrons.

It should be understood that the predetermined minimum distance being smaller than the penetration length the confined electromagnetic modes of the waveguide will typically relate to a distance on the order of hundreds of micrometres or a few millimetres along the surface direction of the waveguide, e.g. parallel to the surface of the waveguide, into the vacuum.

It should be noted that controlling and/or steering of the various elements of the system such as electron sources, beam splitters or collimators may be done by internal or external processors /CPUs, ASICs or the like which are well understood. Further, the controlling of the electron detector may be performed by internal and/or external computers or CPUs. The measured data may be stored on external or internal storage media and may be evaluated / analysed using state of the art programs.

In the system according to the first aspect, the electron source may be a free-electron source.

The system according to the first aspect may further comprise: more than one optical waveguide wherein the photons generated by each of the more than one optical waveguides are phase-matched with respect to the incident electron beam.

We note that although a diamond waveguide is considered in the calculations used as examples below, other materials usually employed in photonic circuits such as silicon or germanium could also be appropriate for interaction. Indeed any dielectric materials capable of supporting confined waveguide modes that penetrate into the surrounding vacuum and present negligible losses in the near infrared and visible frequency range could be suitable for this invention.

The system, according to the first aspect, may further comprise: at least one of the optical waveguides can have external light injected into the waveguide from an external light source, the external light giving rise to respective excited electromagnetic modes confined within the waveguide, and the at least one of the optical waveguides having the external light is configured to interact with the electron beam.

Thus, the system may comprise one or multiple waveguides. Each of these waveguides may interact with an electron of a laterally split electron, as described above. Each of these waveguides can be used in a modality in which light, e.g., laser light, is injected into one or more of the waveguides, so that the electron interacts with externally injected light. The interaction per photon is described by the same matrix elements as in the rest of this disclosure. This interaction with externally injected light can be used to affect the electron, i.e. modulate its wave function. In addition, it can be used to generate exotic forms of light; this results from the modified photon state in the waveguide produced when the electron absorbs or emits a certain number of photons, which can be determined by measuring the electron spectrum; the detection of an electron that has lost or gained energy corresponding to a certain number of photons *N* heralds the generation of a photon state given by (*a*⁺)*^{N}*|*a* > or *a^{N}*|*a* >, where *a*⁺ and *a* are photon creation and annihilation operators, and |*a >* is the externally supplied photon state, e.g., a coherent state.

In the system according to the first aspect, the electron detector may include an electron spectrometer configured to measure a current of the incident electron beam as a function of the energy of the electron beam.

In the system according to the first aspect, the system may further include a monochromator configured to monochromatize the energy of the electron beam before interacting with the at least one waveguide and before entering the electron spectrometer.

The system according to the first aspect may further comprise: one or more lateral electron beam shaping elements such as bi-prisms and/or beam splitters, wherein at least one of the one or more beam shaping elements is configured to split the electron beam into two separate paths of electron beams of a predefined amplitude ratio.

In the system according to the first aspect, the predefined amplitude ratio may be 50% / 50%.

The system according to the first aspect may further comprise: the at least one of the one or more beam shaping elements are configured such that the two separate paths of electron beams interact one after another with only a single waveguide.

The system according to the first aspect may further comprise: the at least one of the one or more beam shaping elements is configured such that only one of the two separate paths of electron beams interacts with a single waveguide two or more times.

The system according to the first aspect may further comprise: at least two optical waveguides, wherein the at least one of the one or more beam shaping elements is configured such that each of the two separate paths of electron beams interacts with a different optical waveguide, respectively.

The system according to the first aspect may further comprise: another one of the one or more beam shaping elements is configured to recombine the two separate paths of electron beams after at least one of the two separate paths of electron beams has interacted at least once with the one or more waveguides, in order to erase distinguishability of the two separate paths of electron beams.

The system according to the first aspect may further comprise: the electron detector is further configured to measure an intensity of the beam of electrons after having interacted with the waveguide, in order to herald generated states of light of the photons emitted from the waveguide, such as NOON states.

With our method, the number of photons in the NOON states can be much higher, for example larger than 10, and can be generated at larger rates, e.g. kHz-MHz, than with existing methods. For example, the previous record using other techniques is about 5 photons generated at a sub-Hz rate [6].

The system according to the first aspect may further comprise two subsystems, wherein the electron source of the second subsystem is configured to provide a second incident beam of electrons, wherein the second subsystem includes one or more second lateral electron beam shaping elements such as bi-prisms and/or beam splitters, wherein the at least one of the one or more beam shaping elements is configured to split the second electron beam into two separate paths of second electron beams of a predefined amplitude ratio; wherein at least one of the two separate paths of second electron beams is configured to absorb the heralded states of light of the photons emitted from the waveguide of the first subsystem.

The present invention further discloses a second aspect of a method for quantum sensing and metrology with free electrons according to the system of the first aspect, the method of the second aspect comprising: providing an incident beam of electrons; collimating and focusing the beam of electrons and controlling the collimated and focused beam of electrons such that a trajectory of the collimated and focused beam of electrons such that a distance between at least parts of the trajectory of the electron beam and the waveguide is smaller than a penetration length of the confined electromagnetic modes of the waveguide into the vacuum; generating an electric field according to a predetermined potential difference between the at least one gate element and the at least one optical waveguide the potential difference being between the at least one gate element and the surface of the corresponding at least one optical waveguide, and to control a distance between the trajectory of the electron beam and the at least one optical waveguide as being larger than or equal to a predetermined minimum distance; wherein the predetermined minimum distance is smaller than the penetration length of the confined electromagnetic modes of the waveguide into the vacuum; interacting with the electron beam in that the at least one optical waveguide is configured generate a plurality of photons when the beam of electrons travels along the parts of the trajectory of the beam of electrons being closer to the waveguide than the penetration length of the confined electromagnetic modes of the waveguide into the vacuum, wherein the plurality of photons is to be waveguided within the optical waveguide; measuring an intensity of the beam of electrons after having interacted with the waveguide to detect the plurality of photons waveguided by the waveguide.

In the following, we use the terms "optical waveguide" and waveguide synonymously.

### Brief description of the drawings

- FIG. 1:: illustrates a schematically the interaction of a beam of electrons with the evanescent electromagnetic field of a waveguide;
- FIG. 2:: illustrates a specific example of a trajectory of an electron beam through an electric field between a waveguide and a gate element;
- FIG. 3:: illustrates a specific configuration of a system according to an embodiment according to the present disclosure;
- FIG 4: illustrates a modified configuration of the system shown in FIG. 3, according to an embodiment of the present disclosure;
- FIG. 5: illustrates yet another modified configuration of the system shown in FIG. 3 or FIG. 4, according to an embodiment of the present disclosure;
- FIG. 6: illustrates some components of a system for Quantum Free Electronics according to the present disclosure;
- FIG. 7: illustrates elements of a system for Quantum Free Electronics in a diagrammatical representation, according to the present disclosure;
- FIG. 8: illustrates results relating to the configuration FIG. 7;
- FIG. 9: illustrates further results relating to the configuration of FIG. 7;
- FIG. 10: illustrates a configuration according to the present disclosure, in which Quantum Free Electronics is used to herald exotic states of light;
- FIG. 11: illustrates a comparison between the probability of detecting an electron that heralds the creation of a single mode NOON state;
- FIG. 12: illustrates a further configuration according to the present disclosure, in which Quantum Free Electronics is used to measured exotic states of light such as NOON states;
- FIG. 13: illustrates the electrons measured by the configuration according to FIG. 12;
- FIG. 14: illustrates a combination of two systems of Quantum Free Electronics, wherein one system corresponds to the system of FIG. 10 and the second system corresponds to the system of FIG. 12;
- FIG. 15: illustrates a method of for quantum sensing and metrology with free electrons according to the present disclosure

### Description

We disclose a family of systems that arise from the combination of free-electron optics and waveguided optics. We show that suitably arranged interactions between different spatial components of a which-path free- electron and waveguided modes of light can lead to photon phase measurements displaying super-sensitivity and super-resolution via the detection of free-electron currents. The improvement in resolution and sensitivity is linked to the number of photons generated during the electron-light interactions, which can be in the order of tens for experimentally attainable values. Furthermore, we show that the system enables the generation of NOON states with tens of photons at high rates by performing post-selection over the electron's energy, these states can also be detected with high fidelity through energy- resolved measurements of the electron current intensity.

### Free-electron enabled many photon generation

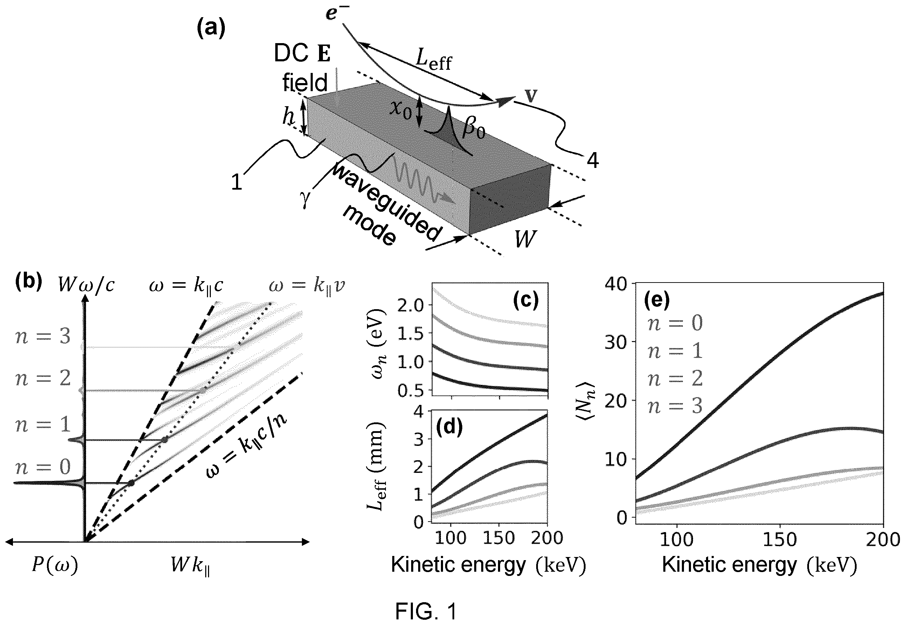

One of the key element of the system and corresponding method of the present disclosure is the ability to produce multiple indistinguishable photons by an individual electron. To achieve this we consider the system schematized in FIG. 1, subfigure (a), where a free electron with well-defined relativistic kinetic energy *E*₀ and momentum *q*₀ interacts with a rectangular waveguide. The electron enters the interaction region with a velocity v = v(-sin *θ***x̂** + cos *θ***ẑ**) where a DC electric field, generated by a potential difference *V*₀ over a vertical distance *a*, is applied such that during interaction the electron follows an approximately parabolic trajectory with a minimum electron-waveguide distance *x*₀, exiting with a velocity v = v(sin *θ***x̂** + cos θ**ẑ**).

In more detail, FIG. 1, subfigure (a) illustrates a free electron *e*⁻ traveling along a trajectory 4 close to a waveguide 1. The distance between the waveguide and the electron *e*⁻ may be controlled by a DC electric field E. In Fig. 1, subfigure (a), for illustrative purposes the electric field E as being normal to the surface of the waveguide 1. The DC electric field serves to bend the electron's trajectory 4 to observe a minimum distance *x*₀ between the trajectory 4 of the electron beam and the waveguide. Here, field lines of the electric field should point towards the surface of the waveguide for the negatively charged electron to be deflected from the waveguide by the electric field. This minimum distance *x*₀ may be predetermined or precalculated and serves to avoid the electron beam hitting the waveguide. This may also serve to avoid coupling of the electron to localized or lossy excitations that might induce a deterioration or even loss of coherence between different electron paths. The waveguide 1 typically extends linearly, e.g. in a straight way. In FIG. 1, the shape of the waveguide 1 is rectangular, i.e. the waveguide 1 having a width *W* and a height *h* and otherwise substantially extending into the third dimension. FIG. 1 further indicates a photon γ, symbolized by a wiggly line. This photon γ schematically symbolizes the generating of a plurality of photons when the electron travels along the waveguide, as will be explained in the following. In other words, in FIG. 1, subfigure (a), a free-electron traveling at a velocity v interacts with the confined modes in a rectangular waveguide, e.g. a diamond waveguide, of width *W,* height *h* and length *L.* During interaction, a DC electric field bends the electron's trajectory 4 which has a minimum electron-waveguide distance *x*₀. Due to the electron's small angle of incidence and the slowly curving trajectory 4, the interaction is approximately phase-matched and takes place over a region of length *L_{eff},* which can be in the order of several hundred microns allowing for strong interaction between the electron and a dominant mode of frequency *ω*₀, for which the interaction strength is quantified by a coupling parameter *β*₀ > 1.

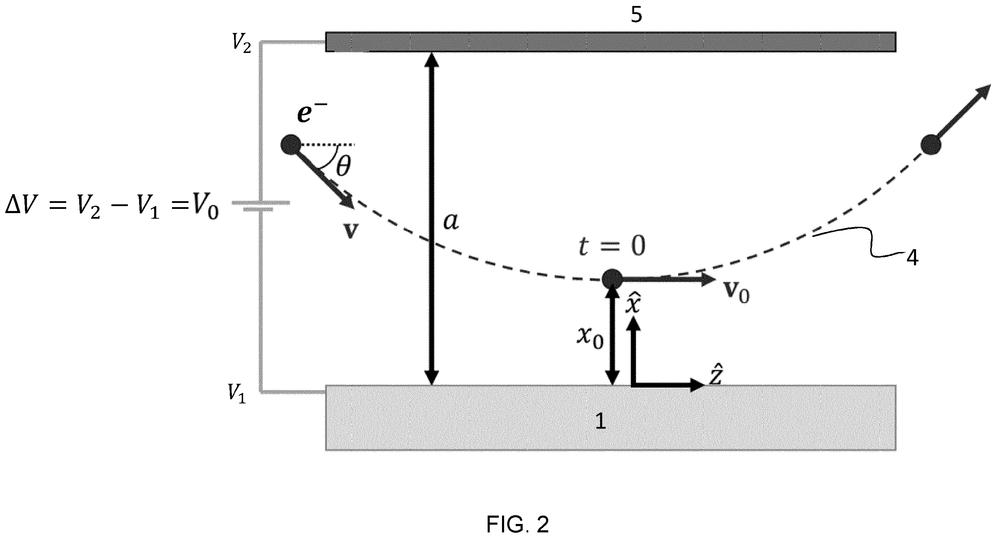

The geometry of the setup of FIG. 1, subfigure (a) is further detailed in FIG. 2. FIG. 2 illustrates a waveguide 1, typically the same as in FIG. 1, subfigure (a), and a gate element 5. The waveguide 1 of FIG. 2 is substantially rectangular. The distance between the gate element 5 and the waveguide 1 is indicated by *a.* The gate element 5 may be at a potential V2, whereas the waveguide 1 may be at a potential V1, resulting in a potential difference of Δ*V = V*₂ *- V*₁ *= V*₀ and giving rise to an electric field *E = V*₀/*a.* The trajectory 4 of the electron having a velocity v and an angle of incidence *θ* is indicated as a dashed line. The minimum distance *x*₀ between the waveguide 1 and the corresponding minimum of the trajectory 4 of the electron *e*⁻ is indicated, as are the respective Cartesian coordinates *x̂* and *ẑ*. It should be noted that while for illustrative purposes, FIG. 2 shows the trajectory 4 of the electron *e*⁻ traveling between the waveguide 1 and the gate element 5, the electron *e⁻* may also travel outside the region between the waveguide 1 and the gate element 5. It should be noted that the dimensions of the drawings of FIG. 2 are out of scale and thus, FIG. 2 serves for illustrating the underlying principles. Typically, the electron would have to be further away from the gate element than it ever is from the waveguide as is should not couple to any excitations associated with the material of the gate element.

Returning to FIG. 1, and in view of FIG. 2, the relation of FIG. 1, subfigure (a) and subfigures (b), (c), (d), and (e) should be further described. For a small angle of incidence of the electron beam *θ* « 1 and a low- intensity external field *E= V*₀/*a,* changes to the trajectory 4 of the electron are slow, such that the interaction can be considered to be approximately phase-matched [11] with the frequencies of the excited modes given by the intersections between their dispersion curves and the one of the electron, which is linear up to first order *ω* ≈ *vq,* see FIG. 1, subfigure (b) and subfigure (c). Under these conditions the frequency-defined electron-light interaction probability can be estimated as *P*(*ω*) = *L*_{eff}(ω)*dP*(0, *ω*)/ dz where *dP*(*x, ω*)/*dz* = (*e*/*π* 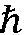 *ω*)Re{**v** · **E**(*x*, *ω*)} is the instantaneous interaction probability per unit length, with **E**(x, *ω*) the electric field at the position of the electron and v ≈ vz. This probability is obtained by employing a robust boundary element methods scheme [13]. Furthermore, *L_{eff}* is a frequency-dependent effective interaction length which encapsulates the information of the overlap between the electron's trajectory 4 and the electromagnetic modes in vacuum. Due to the evanescent nature of these fields *dP*(*x, ω*)/*dz* decreases as e^{-2*x*/*λ*_{⊥,ω}}, with *λ*_{⊥,*ω*} the penetration length of the confined electric fields at frequency *ω* into the surrounding vacuum. Thus, the effective length can be obtained by integrating e^{-2*x*/*λ*_{⊥,ω}}, over the electron's trajectory 4, which results in ${L}_{eff} \left(ω\right) = {e}^{- \frac{2 {x}_{0}}{{λ}_{⊥ , ω}}} \frac{2 {am}_{e} cvγ}{{eV}_{0}} {e}^{\frac{2 {amc}^{2} γ}{{eV}_{0} {λ}_{⊥ , n}}} {K}_{1} \left(\frac{2 {amc}^{2} γ}{{eV}_{0} {λ}_{⊥ , n}}\right)$ where *K*₁(*x*) is the first order modified Bessel function of the second kind, with *mₑ* and *e* the electron's mass and charge respectively. In FIG. 1, subfigure (d), we see the effective length favors low-frequency excitations, producing negligible coupling to higher energy modes. The frequency-defined probability for a 200 keV electron and realistic waveguide dimensions is shown in FIG. 1, subfigure (b), where we see sharp peaks centered at the excited frequencies. Finally, the probability *Pₙ* of generating photons of a given frequency *ωₙ* is given by the area under the corresponding peak and we note it can exceed unity as it has to be interpreted as the mean 〈*Nₙ*〉 of a Poissonian distribution for the number of photons generated in the system during the interaction. In FIG. 1, subfigure (e) we show the photon generation probability *Pₙ* = 〈*Nₙ*〉 for waveguides of realistic dimensions and electron with kinetic energies within ranges used in electron microscopes, which for swift electrons may be in the order of ~ 40 photons each of about 0.48 eV. Thus, in FIG. 1, subfigure (b) the frequency- defined electron-light interaction probability *P(ω)* (left), where the peaks correspond to the intersection between the dispersion curves (solid lines, right) and the electron line (dotted line, right) for a 200 keV electron (v *≈ 0.7c*)*.* The dashed lines represent the light line in free space and inside the waveguide, between which the modes are confined. In FIG. 1, subfigure (c), frequencies are illustrated, whereas in subfigure (d) an effective interaction length is illustrated. Finally, in FIG. 1, subfigure (e), a photon generation probability for the four dominant modes during interaction for different kinetic energies of the electron. The modes shown in subfigures (c-e) are matched with their counterparts in panel (b). As indicated above, we set the dimensions of the waveguide as W = 400 nm, *h = 800* nm, the electron-waveguide distance at *x₀* = 60 nm and *V*₀/*a* = 10 V/mm in all subfigures, but other parameters may be used, as well.

The following should be considered: if one would just take an electron beam, e.g. a collimated and focused beam, the beam interacting with one waveguide, it can generate N-photon states in the waveguide. These states may be heralded by the detection of an electron after interacting with the waveguide where the electron has lost an energy *N*ℏ*ω*, where *ω* is the frequency of those photons. This requires the electron to be monochromated before the interaction, i.e. having a lower energy width than the photon energy. The novelty of the present disclosure relates to the fact that, by using DC fields to maintain a minimum distance of electron-surface interaction, the electron beam only couples to the photonic modes, i.e. the waveguided modes that corresponds to photons, and the electron beam is not contaminated by energy losses associated with non-photonic modes, e.g., electron-hole pairs in the material. In addition, the length of the trajectory of the electron near the waveguide is made large, thus producing a large electron-waveguided-photon coupling, and generating a high N multiphoton state, i.e. a Fock state with a high photon number.

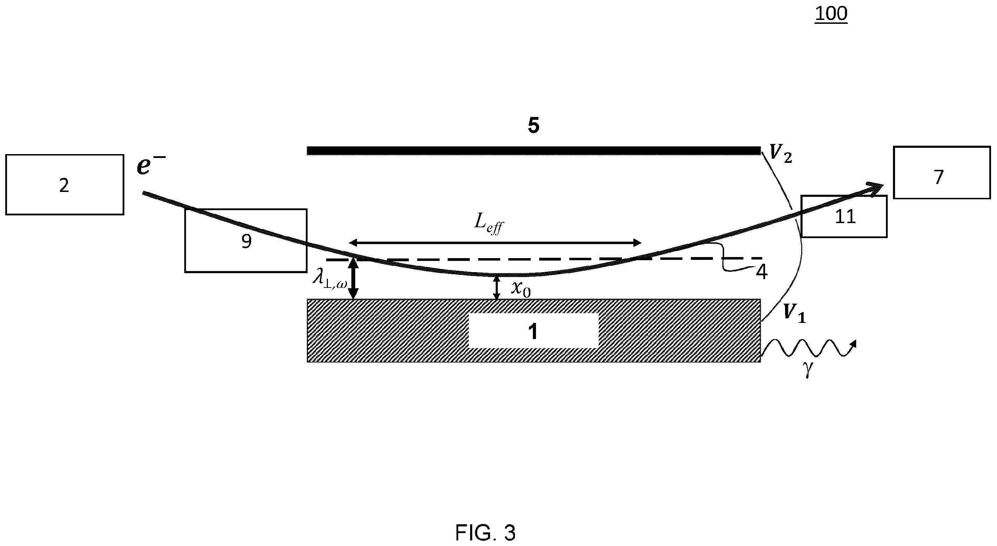

FIG. 3 schematically illustrates the setup of FIGs. 1 and 2 according to an embodiment of the present disclosure. FIG. 3 illustrates a system 100 for quantum sensing and metrology with free electrons according to the present disclosure. In FIG.3, the system 100 comprises an electron source 2 emitting free electrons towards an optical waveguide 1. The free electrons emitted by the electron source 2 have a predetermined electron energy and momentum. These electrons form a beam of electrons following or traveling along a trajectory 4. FIG. 3 illustrates that beam collimating and focusing elements 9 may be used to focus and collimate the beam of electrons towards the waveguide 1. Beam collimating and focusing elements for electron beams are well understood and are not further detailed, here. As explained with respect to FIG. 2, the trajectory 4 of the electrons emitted from the source 2 will have a minimum distance, cf. distance *x*₀ in FIG. 2 with respect to the waveguide 1. It should be understood that typically, this distance is measured normal to the surface of the waveguide 1. FIG. 3 further illustrates *λ*_{⊥,*ω*} being the penetration length of the confined electric fields at frequency *ω* into the surrounding vacuum. FIG. 3 further illustrates the *L_{eff}* is a frequency-dependent effective interaction length, cf. the discussion, above. The distance *x*₀ may be controlled by an electric field between the waveguide 1 and a gate element 5 as illustrated in FIG. 3, see also FIG. 2. The electric field is a DC electric field and it arises due to a potential difference between the gate element 5 and the waveguide 1, where for illustrative purposes the potentials are indicated by *V*₂ and *V*₁. FIG. 3 further illustrates that within the electric field the trajectory 4 of the electron beam has an approximately parabolic or hyperbolic shape. FIG. 3 further illustrates that photons are generated and waveguided and potentially may be emitted from the waveguide 1 due to the interaction of the electron with the waveguide 1. Further, FIG. 3 illustrates an electron detector 7 to detect the electrons to gather information about the generated photons. Further, FIG. 3 illustrates element 11, i.e. that lateral electron beam shaping elements such as bi-prisms and/or beam splitters may be used to further act on the electron beam before being measured by the electron detector 7. In other words, FIG. 3 illustrates an interaction region. The interaction region is where the coupling coefficient between the electron and the waveguided modes approaches unity-that is, where the interaction is strong enough for the probability of photon generation to be non-negligible. The extension of this region may be determined by computing the electron's trajectory based on the electrons velocity, angle of incidence, and the intensity of the static field. By comparing the electron's vertical distance from the waveguide 1 along its trajectory 4 with the penetration length *λ*_{⊥,*ω*} of the electromagnetic modes, we may estimate the extent of the interaction region. Specifically, the interaction region corresponds to the horizontal segment along which the electron's vertical distance from the waveguide surface is smaller than the penetration length *λ*_{⊥,}*_{ω}.* Again, the electron-waveguide distance should be smaller than the penetration length *λ*_{⊥,*ω*} of the desired waveguided modes while remaining larger than the penetration length of modes associated with high losses or short propagation distances, such as plasmons, or localized material excitations. Typically, the closest distance between the electron and the waveguide in this configuration as well as further configurations of FIGs. 3 to 14 is around 50 nm, with the penetration length of the dominant mode around 140 nm, for example. In other words, the interaction length can range from a few micrometres to several millimetres, depending on the electron's initial velocity, angle of incidence, and the strength of the static field. For multiple photons to be generated-and thus for the system to operate optimally-the interaction length would typically fall within the range of 400 microns to 4 millimetres, based on the example given in the present disclosure for a 200 keV electron. However, it should be noted these values are sensitive to the specific geometry and dimensions of the waveguide, as well as the electron's initial conditions.

The penetration length of the waveguided modes can be estimated either numerically or experimentally. Numerically, estimating involves electromagnetic simulations of the waveguide based on the specific material, geometry, and dimensions used. Experimentally, one possible approach is electron energy loss spectroscopy (EELS), using free electrons traveling parallel to the waveguide at fixed distances to map how the field decays with distance. In both methods, the field amplitude is expected to decay exponentially as exp(-*d*/*L*), where *d* is the electron-waveguide distance and *L* is the penetration length, allowing it to be extracted from the field profile.

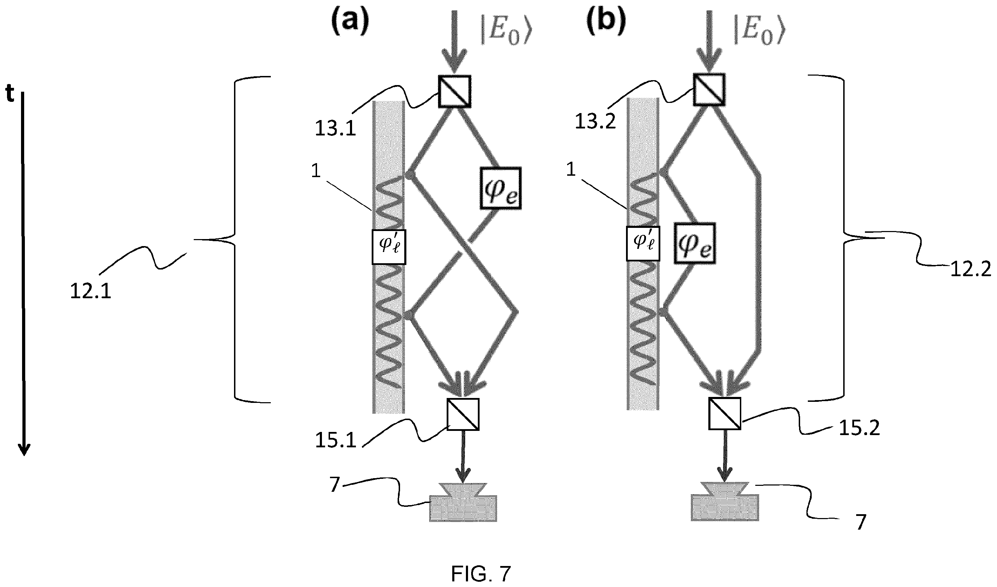

For the embodiment of FIG. 3 and all of the following embodiments, in particular FIGs 7, 10, 12, and 14, it may also be possible to inject external light into one or more of the waveguides 1, e.g. by using an external light source such as a laser (not shown). Thus, at least one of the optical waveguides 1 may have external light injected into the waveguide from an external light source. The external light then gives rise to respective excited electromagnetic modes confined within the waveguide, and the at least one of the optical waveguides having the external light is configured to interact with the electron beam. Thus, beyond having just electromagnetic modes in the ground state, we may also have electromagnetic modes in an excited state.

In other words, the system may comprise one or multiple waveguides. Each of these waveguides may interact with a path of a laterally split electron, as described above. Each of these waveguides can be used in a modality in which light, e.g., laser light, is injected into one or more of the waveguides, so that the electron interacts with externally injected light. The interaction per photon is described by the same matrix elements as in the rest of this disclosure. This interaction with externally injected light can be used to affect the electron, i.e. modulate its wave function. In addition, it can be used to generate exotic forms of light; this results from the modified photon state in the waveguide produced when the electron absorbs or emits a certain number of photons, which can be determined by measuring the electron spectrum; the detection of an electron that has lost or gained energy corresponding to a certain number of photons N heralds the generation of a photon state given by (*a*⁺)|*a* > or *a^{N}*|*a* >, where *a*⁺and a are photon creation and annihilation operators, and |*a* > is the externally supplied photon state, e.g., a coherent state.

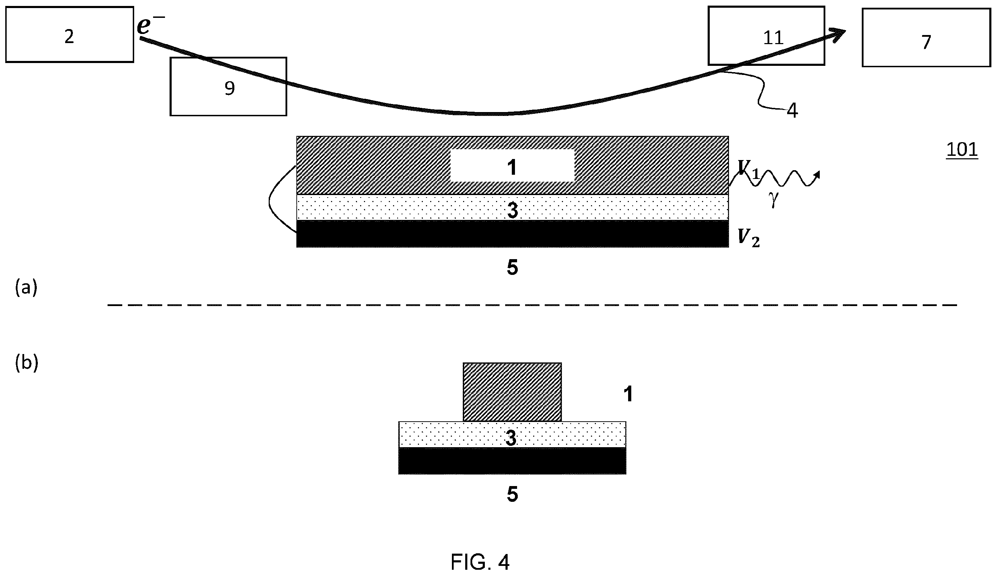

FIG. 4 illustrates a further embodiment of the present disclosure, similar to the embodiment illustrated in FIG. 3. FIG. 4 illustrates a system 101 for quantum sensing and metrology with free electrons according to the present disclosure. In FIG. 4, the same elements are denoted with the same reference signs. In the upper part of FIG.4, i.e. subfigure (a), it is now illustrated that the trajectory 4 of the electron beam does not travel through a region 3 between the gate element 5 and the waveguide 1 but rather outside the region 3, but still close to the waveguide 1. Here, the electric field, as described with respect to FIGs 2 and 3, is still capable of deflecting the electron beam so as not to hit the waveguide 1. FIG. 4, subfigure (b) illustrates a cross sectional view of the waveguide 1, the gate element 5 and the region 3. Here, it should be noticed that the waveguide may have a rectangular cross section.

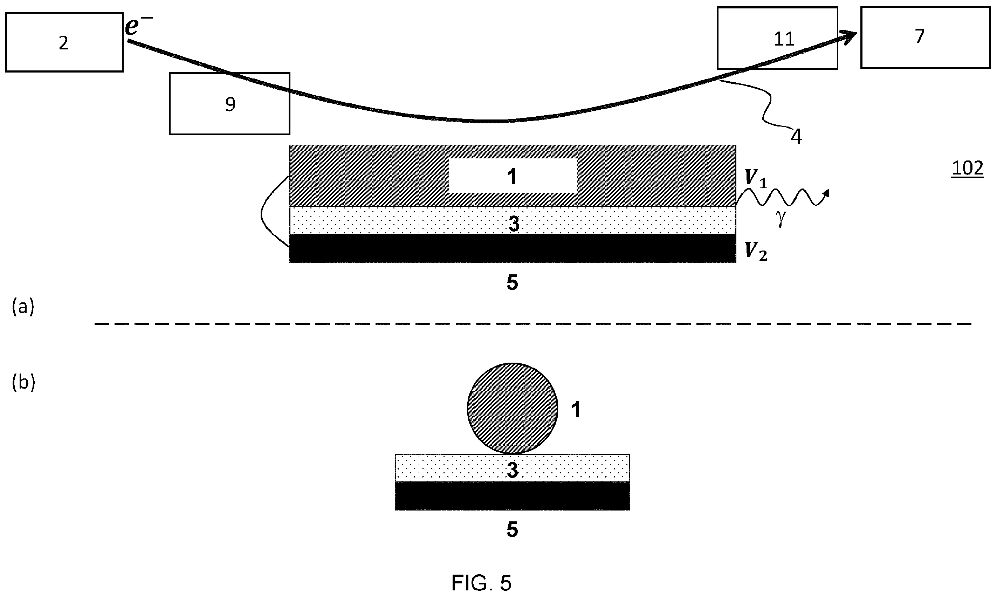

FIG. 5 illustrates a further embodiment of the present disclosure, similar to the embodiments of FIGs 3 and 4. FIG. 5 illustrates a system 101 for quantum sensing and metrology with free electrons according to the present disclosure. Again, the same elements will be denoted with the same reference signs. FIG. 5, subfigure (a) is similar to FIG. 4, subfigure (a). In FIG. 5, subfigure (b), the waveguide is shown to have a substantially circular cross-section.

### Quantum Free Electronics

In the following, we propose taking advantage of the high photon generation probabilities by using a free-electron source such as the free electron source of FIGs. 1 to 5, together with one or multiple identical waveguides, such as the waveguide of FIGs 1 to 5, in a method we denominate Quantum Free Electronics (QUAFE). The initial state of a QUAFE system is given by a product state |*ψᵢ*〉 = |ϕ^{inc}, *E*₀〉 ⊗ |*ψ*_{ℓ,*i*}〉, where the electron is characterized by the spatial profile of its wave function φ^{inc} and its kinetic energy *E₀,* while the light can have a more general state |*ψ*_{ℓ,*i*}〉. The interaction between the electron and a single waveguide is incorporated into this formalism by the scattering operator 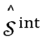 = Π*ₙ* 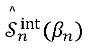 defined as the product of the single-mode interaction operators ${\hat{S}}_{n}^{int} \left({β}_{n}\right) = exp \left\{-{β}_{n}^{∗}{\hat{a}}_{n}{\hat{b}}_{n}^{†}+{β}_{n}^{∗}{\hat{a}}_{n}^{†}{\hat{b}}_{n}\right\} .$ (1) which we include for each waveguided mode n with a non-negligible probability of interacting with the electron, see the annex of this application. Here *âₙ*, ${\hat{a}}_{n}^{†}$ are the usual bosonic operators that act on the light-states annihilating and creating quanta of energy 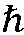 *ωₙ*, while *b̂*ₙ and ${\hat{b}}_{n}^{†}$ act on the electron energy states performing the same action as *b̂ₙ*|*E*₀〉 *=* |*E*₀ *-* 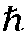 *ωₙ*〉 and ${\hat{b}}_{n}^{†} \left|\left.{E}_{0}\right〉\right. = \left|\left.{E}_{0}+{ℏω}_{n}\right〉\right.$*.*

The strength of the electron-light coupling is given by the single-mode coupling coefficient *βₙ*, which is related to the photon-generation probability as |*βₙ*|² *= Pₙ.* We note that different from the photon operators, those of the electron commute as *b̂b̂*^{†} = *b̂*^{†}*b̂ =* 1. From the shape of Eq. (1) it is clear that the interaction entangles the electron's kinetic energy with the state of the light, meaning one can herald the state of the other [12].

Independent operations can also be performed both over the light and electron states, such as beam splitting and mixing, the introduction of phase shifts, and measurements. Beam splitters (BS) can be incorporated to separate a single electron, or likewise each photon, into a spatial superposition of two paths of equal amplitudes, i.e. a beam splitter (BS) with 50%:50% splitting, also denoted as a "50/50 BS", with no spatial overlap between them. Similarly, the time-reversed operation can be used to recombine two such paths into a single one, by taking advantage of destructive and constructive interference occurring for each of the output paths. Methods for beam splitting waveguided modes of light are well established [14], while for electrons a grating or biprism can work to split the beam into two paths with high fidelity. Both electrons and photons will acquire phases in between operations, associated with the effective distances traveled during propagation, and which can modify the final state of the system. Phases could be either introduced at will or as a consequence of external effects, such as changes in the refractive index of the waveguides or elastic interactions, allowing for indirect detection. For an electron of momentum q₀ or a photon of energy 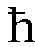 *ω* that travels a distance Δ*x*, the respective phases acquired are *φₑ = g*₀Δ*x* and *φ_{ℓ} = ω*Δ*x*/*c.* In the case where we have a multimode photon state, we assume in this work that all modes follow the same path, such that the phase *φ_{ℓ,n}* acquired by a given mode n can be written as *φ_{ℓ,n} = φ_{ℓ}ωₙ*/*ω*₀ with *φ_{ℓ}* the phase gained by the lowest frequency mode *n =* 0. The final operation, measurements, we consider are performed exclusively over the electrons, which contain information about the state of the photons due to the entanglement introduced during the interaction.

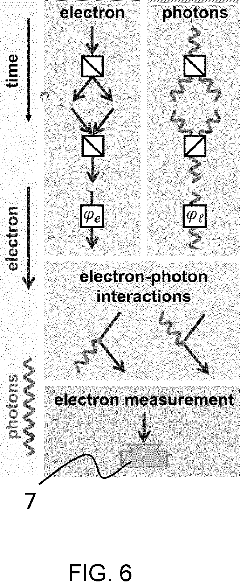

The operations described in this section are the building blocks of QUAFE systems. Every system can be represented as a diagram constructed by combining the elements shown in FIG. 6. We set the convention of time flowing downwards in the diagrams. Given the initial state of the system, each of these diagram elements is linked to a mathematical operation that is applied over it in the order of appearance. Thus, FIG. 6 illustrates some components of the QUAFE, which may include beam splitters and/or gratings and/or mixers, and phase-shifts for electrons *φₑ* and photons *φ_{ℓ},* the electron-photon interactions and measurements performed over the electrons. FIG. 6 further illustrates the electron detector, element 7 of FIGs. 3, 4, and 5. The diagrams of FIG. 6 must be read with time going downwards. A summary of the precise mathematical operation linked to each component is given in the annex. It should be noted that the interactions shown in FIG. 6 may occur can occur either before or after the interaction between the electron and the waveguided modes, but not during the interaction between the electron and the waveguided modes.

### Phase measurements and quantum light generation

We now present a few examples in which improved resolution and sensitivity can be obtained through QUAFE. In FIGs 7, subfigure (a) and subfigure (b), we show the waveguide 1 on the left side of the respective subfigure. We show interaction points, i.e. vertices where electrons, indicated by straight lines and photons, indicates by wiggly /curly lines interact within the penetration length of the waveguide, as explained for FIGs. 1 to 6. For FIG. 7 it should be understood that the corresponding vertices are within the penetration length of the waveguide 1 and not closer than the minimum distance *x*₀, as was discussed, again, for FIGs 1 to 6. We start with the system diagrammatically represented in FIG. 7, subfigure (a). FIG. 7 illustrates element 11 of FIGs. 3, 4, and 5. This may apply for element 9 of FIGs. 3, 4, and 5, as well. Further, both subfigure (a) and subfigure (b) of FIG. 7 illustrate an electron detector as in FIGs. 3, 4, and 5. FIG. 7, subfigure (a), illustrates an element 12.1, which may correspond to element 11 of FIGs. 3, 5 and 5. Element 12.1 includes beam splitters 13.1. Here, in subfigure (a), an electron is split into a two-path configuration with each of the paths, i.e. the left path and the right path shown in subfigure (a), interact at different moments with a single waveguide initially prepared in the vacuum state |*ψ*_{ℓ,*i*}〉 *=* |0〉. For the mentioning of different moments in time, it is referred again to FIG. 6 and the description of FIG. 6. Between both interactions shown in subfigure (a), a phase shift is acquired by both the photons and the electron path that has yet to interact. We consider the same single-mode coupling coefficients for both interactions. The two electron paths are then redirected toward a beam mixer that recombines the two beams into a single path in the absence of interaction and for *φₑ* = 0, with the intensity of the outgoing beam *I* being detected. When there is a nonzero phase difference between the two paths the intensity will instead be partially transmitted in a different spatial path that goes undetected. Thus, the intensity *I* will depend on the relative phase of the incoming electron paths determined, in turn, by the strength of the electron-light coupling and the phases. A simple expression can be obtained by considering incident electron plane waves, setting the phase of the electron at *φₑ* = *π*/2 such that *I* = *I₀*/*2* in the absence of interaction resulting in $I ∼ 1 + {e}^{- {\sum }_{n} \left〈{N}_{n}\right〉 \left[1-cos\left({φ}_{l}\frac{{ω}_{n}}{{ω}_{0}}\right)\right]} sin \left[{\sum }_{n} \left〈{N}_{n}\right〉 sin \left({φ}_{l}\frac{{ω}_{n}}{{ω}_{0}}\right)\right]$ (2)

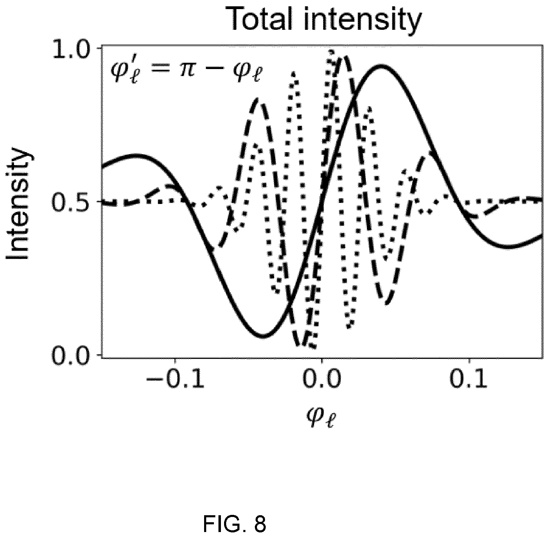

As shown in FIG. 8 for different values of 〈*Nₙ*〉. Analogous results can be obtained from the configuration seen in FIG. 7, subfigure (b). Subfigure (b) illustrates a beam splitter 13.2 which may be similar to the beam splitter 13.1 of subfigure (a). Subfigure (b) illustrates a section 12.2 similar to section 12.1 of subfigure (a). In subfigure (b), a beam splitter 13.2 is shown, where after beam splitting only one of the paths, i.e. the left of the two paths shown in subfigure (b), interacts twice with the waveguide by setting ${φ}_{l}^{′} = π - {φ}_{l}$*.* As anticipated, for large enough interactions, i.e. the dominant mode having 〈*Nₙ*〉 > 1, the intensity measurement displays both super-resolution and super sensitivity associated with changes in the phase of the photons, meaning that it beats both the Rayleigh diffraction limit and the shot-noise limit respectively. We can estimate the resolution as the phase *φ*ᵣₑₛ at which the intensity has its first maxima or minima with respect to *φ_{ℓ}* = 0. Assuming *φ*ᵣₑₛ << 1 we find *φ*ᵣₑₛ ≈ πω₀/(2 Σ*ₙ*〈*Nₙ*〉 *ωₙ*), from which we define an effective number of photons for mode *n = 0 as* ${N}_{eff} = {\sum }_{n} \left〈{N}_{n}\right〉 \frac{{ω}_{n}}{{ω}_{0}} .$ (3)

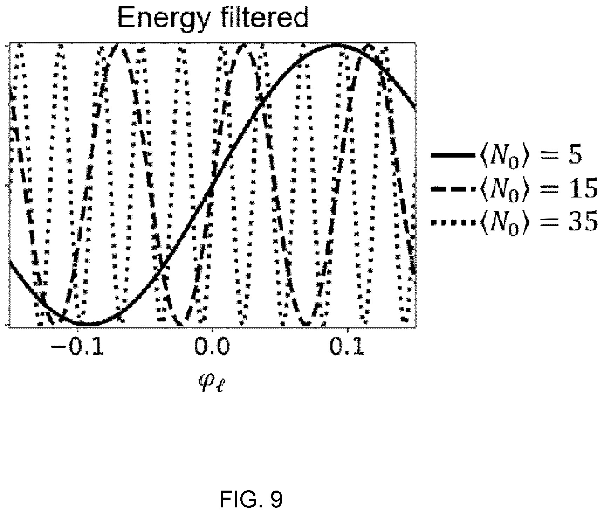

For the parameters considered in FIG. 9, we obtain *N*_{eff} ≈ 7 × 〈*N*₀〉, which explains the sharp features in the intensity. The phase resolution translates to a length resolution of *x*ᵣₑₛ ≈ *λ*₀/4*N*_{eff}*,* with *λ*₀ = 2*πc*/*ω*₀ the wavelength of the dominant mode. The sensitivity in turn can be estimated by looking at the maximum slope of the intensity signal, i.e. ∂*I*/ ∂*_{φℓ},* located at *φ =* 0. The smallest change in path length which can be detected is given by $Δ x \approx \frac{{λ}_{0}}{2 π \sqrt{{I}_{0}} {N}_{eff}} ,$ (4) where $1 / \sqrt{\left〈{N}_{n}\right〉}$ is the shot-noise limit of an interferometer for *λₙ* wavelength light and where we have considered the uncertainty of the electron current as $Δ I = \sqrt{{I}_{0}}$.

From the interference pattern in FIG. 8, we see that while the sensitivity is greatly improved around *φ_{ℓ} =* 0 visibility of the interference pattern drops quickly when the value of *φ_{ℓ}* increases beyond *φ*ᵣₑₛ, which can affect measurements where the phase can take on a large range of values. This can be fixed by introducing energy resolution to the electron measurements. In the configuration of FIG. 7, subfigure (a), for electrons of a given energy *E*_{{*N*ₙ}} = *E*₀ *-* Σ*ₙ Nₙℏωₙ* the intensity presents no loss of visibility with changes in either *φₑ* or *φ_{ℓ},.* Indeed, the intensity in the electron detector for electrons of this energy can be expressed in the simple form $I ∼ 1 + sin \left[\left({\sum }_{n} {N}_{n} \frac{{ω}_{n}}{{ω}_{0}}\right){φ}_{l}+{φ}_{e}\right] .$ (5)

This result shows a resolution similar to the unfiltered case for *Nₙ* ≈ 〈*Nₙ*〉*.* However, improvements over sensitivity quickly become irrelevant if this is all the information extracted from the system since the measured intensity is given by *I*₀ × |*βₙ*|^{2*N*ₙ}ₑ^{-|*β*ₙ|2}/*Nₙ*!, where *N*ₙ! indicates the factorial of *N*ₙ from the Poissonian distribution. This could be fixed by collecting information over a range of energies and post-processing the results to match the resolution of the unfiltered set-up.

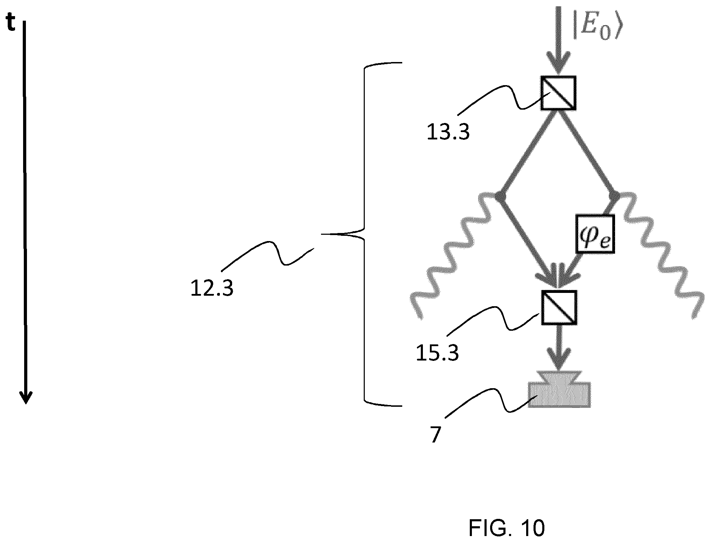

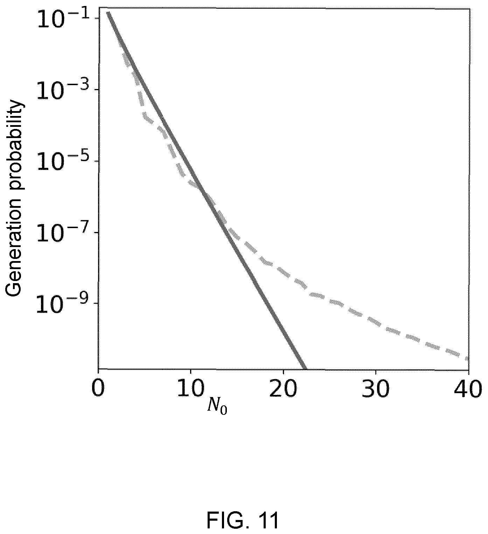

Besides measurements, QUAFE can also be used to generate exotic states of light. An example is the configuration shown in FIG. 10, which can generate high-NOON states. In FIG. 10, for enhanced clarity, an indication of the waveguide 1 has been omitted and only the vertices of electron photon interaction are shown. However, it should be understood that similar as in FIG. 7 the waveguide 1 is present. In more detail, since FIG. 10 shows vertices on the left and on the right side, i.e. for the left and for the right electron path, there are two waveguides involved here. Similar to FIG. 7, FIG. 10 illustrates element 12.3, which may be similar to elements 12.1 and 12.2 of FIG. 7. FIG. 10 further illustrates a beam splitter 13.3 and a recombining element 15.3. FIG. 10 further illustrates an electron detector 7 as in FIGs. 3, 4, 5, and 7. Here, after beamsplitting by the beam splitter 13.3 each path, i.e. the left path and the right path of FIG. 10, of a "two-path" electron interacts with a different waveguide prepared in the ground state or, by injecting external light into the waveguide, in an excited state. The electron paths are then recombined through a BS, which acts as a recombining element 15.3, erasing which-path information for the electron, and an energy-resolved measurement is made. Assuming sufficient energy resolution, the observed energy of the electron unequivocally defines the state of light, as the energy state |*E*_{{*N*ₙ}}〉 *=* |*E*₀ - Σ*ₙ Nₙ* 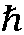 *ωₙ*〉 is entangled with the light state $\left|{ψ}_{l}\right〉 = \frac{1}{\sqrt{2}} \left({\left|\left\{{N}_{n}\right\}\right〉}_{1}{\left|0\right〉}_{2}+{\left|0\right〉}_{1}{\left|\left\{{N}_{n}\right\}\right〉}_{2}\right) ,$ (6) where |{*Nₙ*}〉*ⱼ* = |*N*₀, *N*₁, *... , N_{M}*〉*ⱼ* is the state of light in the waveguide *j =* 1, 2. Thus a reliable generator of specific NOON state can be obtained by setting the system to only detect electrons of a specific energy *E*_{{*N*ₙ}}*.* While NOON states are usually defined for a single mode, e.g. *N*₀ ≠ 0 and *Nₙ* = 0 for n > 0, we shall refer to these as single-mode NOON states and to the more general states, i.e. *Nₙ* ≠ 0 for more than one n, as multi-mode NOON states. If after an electron has passed through the entire system (i.e. after it has been split, each path has interacted with the waveguide and both have been recombined afterwards an electron is detected, we know that the desired NOON state has been generated, on the contrary, the light state can be discarded and the process is started again. The probability of generating a single-mode NOON state, decreases exponentially with the desired number of photons *N*₀, while for a multi-mode NOON state where *Nₙ*/*N*₀ *= βₙ*/*β*₀ it can be seen to decrease at a lower rate for an optimum choice of *β*₀, see FIG. 11. These results imply that for an electron current in the nA, NOON states with *N*₀ = 10, with a total photon number Σ*ₙ Nₙ* ≈ 2.7 × *N*₀ = 27, can be generated at a rate of several thousand per second.

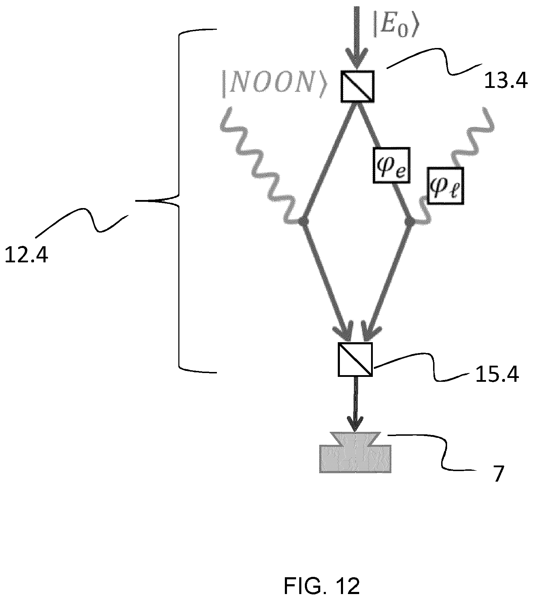

Along with their generation, a similar system can be used to detect these states, the system to do so is schematized in FIG. 12 and is essentially the time-reversed version of the one in FIG. 10 minus one of the BS. Again, In FIG. 12, similar to FIG. 10, for enhanced clarity, an indication of the waveguide 1 has been omitted and only the vertices of electron photon interaction are shown. However, it should be understood that similar as in FIG. 7 the waveguide 1 is present. In more detail, since FIG. 12 shows vertices on the left and on the right, there are two waveguides involved here. Thus, FIG. 12 illustrates a QUAFE configuration for the measurement of a NOON state that has been previously generated by the configuration in FIG. 10. Here, we take Eq. (6) to be the initial state of the waveguides, and consider a phase difference *φ_{ℓ,n}* is accumulated between the photons in the different waveguides. Each electron path then interacts with one waveguide at the same time, after which an energy-resolved measurement returns an interference pattern that presents both super-resolution and super-sensitivity. In other words, FIG. 10 illustrates a Quantum free electronics configuration that allows for the generation of NOON states. The detection of an electron of energy *E*₀ *-* Σ*ₙ Nₙ* 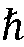 *ωₙ* after interaction means a multi-frequency NOON state has been generated. We note that here an unfiltered measurement produces an interference pattern with a visibility that dramatically decreases with the number of photons, in particular, it can be shown to be similar to the detection probability shown in FIG. 11. FIG. 11 illustrates a comparison between the probability of detecting an electron (right axis) that heralds the creation of a single mode NOON state (solid line), i.e. *Nₙ* = 0 for n ≠ 0, and one that heralds a multi-frequency NOON state (dashed line) where *ω*₀ is the frequency of the mode with the strongest coupling to the electron. We also show the values of *β*₀ for which the probability of getting the electron with the desired energy, and thus the desired state of light, is obtained (left axis). The frequencies *ωₙ* and coupling coefficients *βₙ* for the other modes are taken from the case shown in FIG. 1b-e for a 200 keV electron.

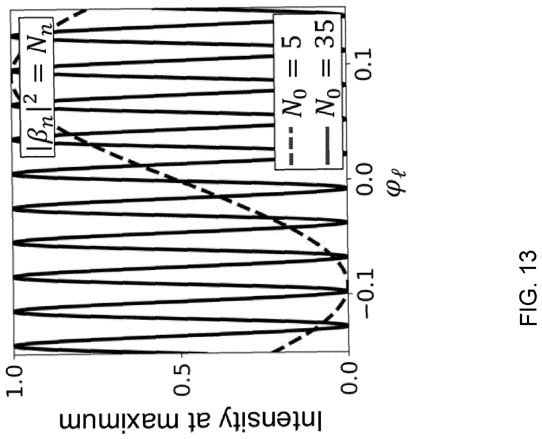

In FIG. 13, we show the intensity corresponding to electrons for which the final energy is *E*₀ *+* Σ*ₙ Nₙℏωₙ,* i.e. those that have absorbed all photons from the NOON state. In other words, FIG. 13 illustrates intensity corresponding to the path obtained after beam recombination in the beam mixer, which is the only path if *φₑ* = 0 and in the absence of interaction for electrons of energy *E*₀ + Σ*ₙ Nₙℏωₙ* as a function of *φ_{ℓ}* for different values of *N*₀*.* The coupling strength is set as |*βₙ*|² = *Nₙ*. The resolution of this scheme is given by *φ*ᵣₑₛ = 2/(π*N*_{NOON}), while the phase sensitivity is $Δ φ = 1 / \left(\sqrt{{I}_{dim}}{N}_{NOON}\right)$ with *I_{dim}* the diminished intensity and where N_{N00N} is equal to Eq. (3) replacing 〈*Nₙ*〉 with *Nₙ.*

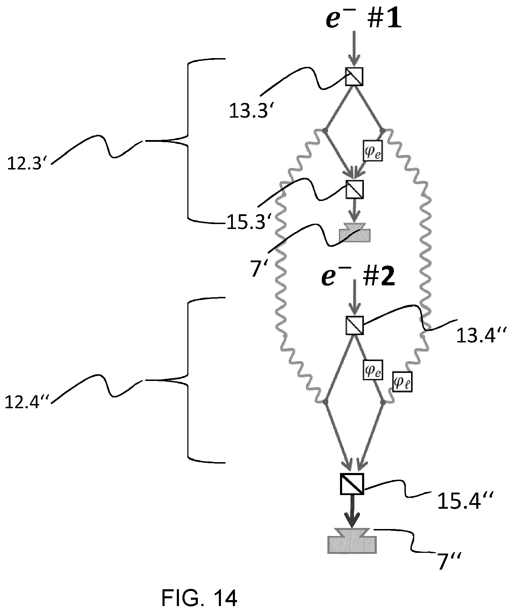

Taking the discussion of FIGs. 10 to 13, FIG. 14 illustrates that two systems of the kind as illustrate in FIGs 10 and 12, or similar to the systems shown in FIG. 7 may be combined, in particular may be sequenced. As in the previous systems, FIG. 10 and 12, two waveguides are involved in this configuration. Thus, FIG. 14 illustrates a first system with electrons, indicated by electron #1 and a second system indicated by electron #2. The first system and the second system, each by themselves, may be similar. The first system with element 12.3', beam splitter 13.3' and re-combining element 15.3' may be used to herald a NOON state as discussed for the system o FIG. 10. The second system with element 12.4", 13.4" may be used to measure the previously heralded NOON states.

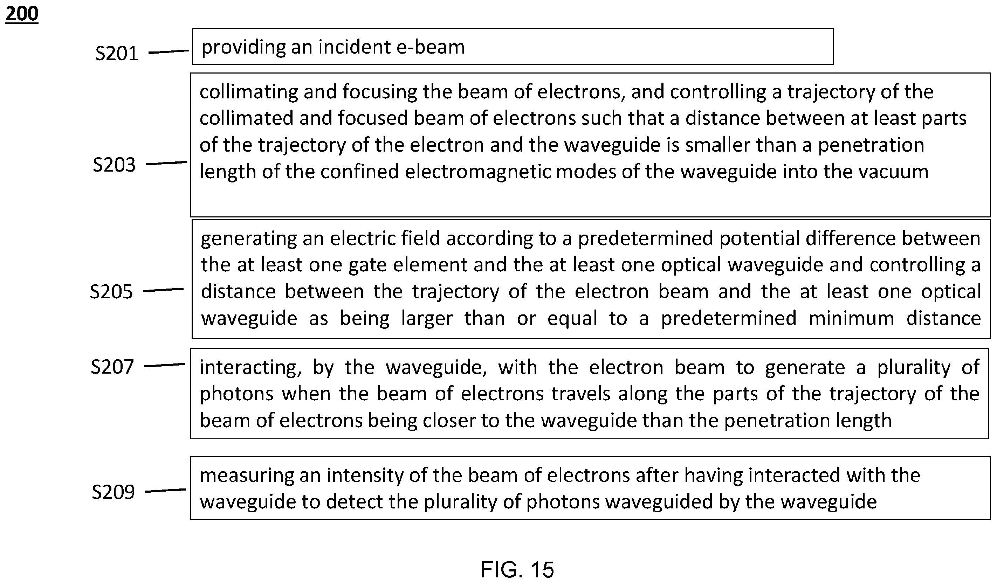

The present disclosure further provides a method corresponding to the system as disclosed with regard to FIGs. 3, 4, 5, 7, 10, 12. This is schematically illustrated in FIG. 15. FIG. 15 a method 200 for quantum sensing and metrology with free electrons according to the system of any one of the previous embodiments, the method comprising the following steps: a step of providing, S20, an incident beam of electrons; a step of collimating and focusing, S203, the beam of electrons and controlling the collimated and focused beam of electrons such that a trajectory of the collimated and focused beam of electrons such that a distance between at least parts of the trajectory of the electron beam and the waveguide is smaller than a penetration length of the confined electromagnetic modes of the waveguide into the vacuum; a step of generating, S205, an electric field according to a predetermined potential difference between the at least one gate element and the at least one optical waveguide the potential difference being between the at least one gate element and the surface of the corresponding at least one optical waveguide, and to control a distance between the trajectory of the electron beam and the at least one optical waveguide as being larger than or equal to a predetermined minimum distance; wherein the predetermined minimum distance is smaller than the penetration length of the confined electromagnetic modes of the waveguide into the vacuum; a step of interacting, S207, with the electron beam in that the at least one optical waveguide is configured generate a plurality of photons when the beam of electrons travels along the parts of the trajectory of the beam of electrons being closer to the waveguide than the penetration length of the confined electromagnetic modes of the waveguide into the vacuum, wherein the plurality of photons is to be waveguided within the optical waveguide; and a step of measuring, S209, an intensity of the beam of electrons after having interacted with the waveguide to detect the plurality of photons waveguided by the waveguide.

### SUMMARY

In the present disclosure, we proposed a novel method in which the quantum nature of electrons and their strong interactions with wave-guided modes of light are leveraged to perform phase measurements displaying super-resolution and super-sensitivity from the detection of current intensity of a free electron beam. The increase in resolution and sensitivity obtained is proportional to the strength of interaction, specifically to an effective number of photons exchanged with the confined electromagnetic modes, which depends on both the average number of photons exchanged and the wavelength of the modes involved in the interaction. Indeed, an electron interferometer with no energy definition is enough to sense small phase variations tens of times smaller than the wavelength of the photons generated by interaction, while energy resolution can enhance the results when dealing with larger variations. Furthermore, we show that quantum states of light, particularly multi-frequency NOON states with tens of photons in the dominant mode can be generated with a unit probability every 0.1 ms for realistic parameters achievable with current technology. Detection of these same states is also possible with this configuration, displaying greatly enhanced resolution and sensitivity.

While here we mainly focus on the generation of NOON states, the methods disclosed by the present disclosure may also be used to generate different type of quantum states of light. Successive interactions with dynamically varying parameters that modify the electron's trajectory, and thus the interaction strength and frequencies, could be taken into account to produce more complex results, such as continuous variable states.

This present disclosure presents new possibilities for quantum technologies where electrons appear as a tool to access regimes that were previously inaccessible, such as high-rate generation of exotic states or a straightforward way of producing highly-sensitive measurements. These results inaugurate a disruptive quantum technology relying on free electrons and their strong interaction with waveguided light.

### ANNEX

### Beam splitters and mixers

For the single-electron the beam splitter, BS, acts on the spatial components of its wave function by converting an incident two-path superposition *A*|*ϕ_{A}*〉 *+ B*|*ϕ_{B}*〉 into a different superposition *C*|*ϕ_{C}*〉 *+ D*|*ϕ_{D}*〉. The transformation is described by a linear transformation that relates their amplitudes as (*C, D*)*^{t} = M ·* (*A, B*)*^{t}* mediated by a matrix *M* For a lossless BS the general form of the transformation matrix is where *θ, χ_{R},χ_{T}* and *χ*₀ are parameters that depend on the specific configuration utilized. The results presented here are produced for 50/50 beam splitters $\left(θ=\frac{π}{4}\right)$ taking *χ*₀ = *χ_{R} = χ_{T}* = 0. By having the incident state by a single-path configuration (e.g. *A =* 1 and *B* = 0) we obtain the two-path superposition $M = {e}^{i {χ}_{0}} \left(\begin{matrix}{e}^{i {χ}_{R}} sin θ & {e}^{- i {χ}_{0}} cos θ \\ {e}^{i {χ}_{T}} cos θ & - {e}^{- i {χ}_{R}} sin θ\end{matrix}\right)$ extensively used in this work, e.g. for *A* = 1 and *B* = 0 we get C = *D =* 1/2. On the other hand, a single-path electron can be recovered from a two path superposition by having the two incident channels have the same amplitude (|*A*| *=* |*B*|) and a phase difference equal to *mπ* with *m* ∈ Z.

For the photons in a given mode *n,* the procedure is similar, with the main difference that it is performed over the boson operators *â_{n,j}* corresponding to four different paths, i.e. in this case waveguides, each labeled *by j* = 1 - 4 as (*â*_{*n*,3}, *â*_{*n,*4})*^{t}* = *M* · (*â*_{*n,*1}*, â*_{*n,*2})*^{t}.* This means that for an arbitrary photon state the transformation will result in a more complicated superposition representing all the combinations of each photon in waveguide 1, 2 going to 3 or 4 with a probability depending on the particular BS.

### Phase shifts

For electrons the phase shift operation is rather straightforward as it consist in appending a e^{i*φ*ₑ} factor to the corresponding spatial component. For example, for a two-path electron $\left(\left|{ϕ}_{A}\right〉+\left|{ϕ}_{B}\right〉\right) / \sqrt{2}$ acquiring a phase shift *φₑ* in path A we obtain $\left({e}^{i {φ}_{e}}\left|{ϕ}_{A}\right〉+\left|{ϕ}_{B}\right〉\right) / \sqrt{2}$*.* For photons, we must take into account that the phase shift is acquired by each quanta while the state propagates. To introduce the phase shift we can decompose the state of light into an expansion in number states basis |*ψ*_{ℓ}〉 = Σ_{{*N*ₙ}} *φ*_{{*N*ₙ}}|{*Nₙ*}〉 and replace |*Nₙ*〉 by e*^{iN_{nφℓ,n}}*|*Nₙ*〉 for each mode. If the light state has been generated from a vacuum state by electron-light interactions, the properties of 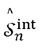 suggest that the phase *φ_{l,n}* should be appended to the single-mode coupling coefficient *βₙ* → e^{-iφ_{ℓ,n}}βₙ of the interaction that has generated said light.

### Electron-light interaction

Electron-light interactions are responsible for coupling the photons and electrons in a QUAFE system. The interaction between an electron and the modes confined in a waveguide are incorporated into the formalism via the operator shown in Eq. (1).

A general initial configuration, before any interaction takes place, is given by an electron of kinetic energy |*E*₀〉 in an *Mₑ* -path configuration, and light in *M_{ℓ}* waveguides in a general state |*ψ*_{ℓ}〉, described by the product state $\left|{ψ}_{i}\right〉 = {\sum }_{j = 1}^{{M}_{e}} \left|{ϕ}_{j}\right〉 \left|{E}_{0}\right〉 \left|{ψ}_{l}\right〉$*.* The evolution of the state can be written in terms of the interaction operator shown in Eq. (1). After one "interaction event", where each electron path *j* interacts only with a single waveguide *k*, the state of the system is given by 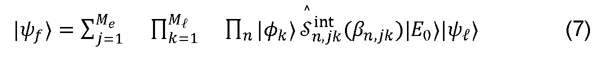 where *β_{n,jk}* is the single-mode coupling coefficient for the interaction between electron path j and mode *n* confined in waveguide *k.* Successive interactions can be added by multiplying a new set of interaction operators 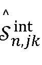 from the left in each term of the sum.

When working with several interactions, it is useful to take into account the properties of the operator 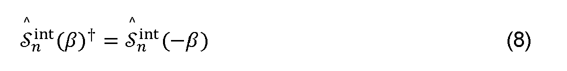 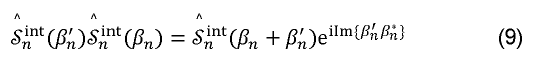 and the explicit form of the matrix elements with respect to the number states of electrons and energy of electron states 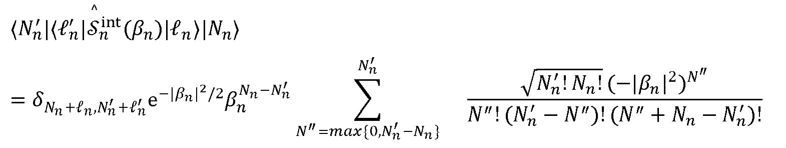 where we write |*E*₀ + Σ*ₙℓₙ* 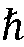 *ωₙ* = |{ℓ*ₙ*}〉 for simplicity assuming non-degenerate energy states are generated during the interaction.

### Measurements

Intensity measurements involve counting the number of electrons which hit a detector such as an electron detector, at a position x in a given time window. Mathematically, this information is given by the density function of the electrons *ρₑ*(***r***) *=* 〈**r**|*ρₑ*|**r**〉, calculated in turn from the electron's density matrix, obtained by taking the density matrix of the full system *ρ* = |*ψ*〉〈*ψ*|, assuming all runs of the experiment are identical, and tracing out the degrees of freedom of light as ${ρ}_{e} = {\sum }_{\left\{{N}_{n}\right\}} \left〈\left\{{N}_{n}\right\}\right| ρ \left|\left\{{N}_{n}\right\}\right〉$*.* For a measurement of the whole electron wave function, we also have to trace out the degrees of freedom associated with the energy of the electron as Σ_{{ℓₙ}} 〈{ℓₙ}|*ρₑ*|{*ℓ*ₙ}〉*,* while for the energy- filtered electrons we instead take the expectation value of the operator at the desired energy, i.e. 〈{ℓ*ₙ*}|*ρₑ*|{ℓ*ₙ*}〉. Due to the completeness of the basis of number states for the photon and electron energies and due to 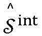 acting on these components of the wave function, in the former case the two trace operations can be replaced by taking the absolute value of the state, after representing the spatial components of the electron in real space 〈**r**|*ψ*〉. In the case of the energy filtered measurement the same can be achieved by also projecting the state in the desired energy state 〈{ℓ*ₙ*}|(**r**|*ψ*〉.

When instead post-selecting the electrons over energy to herald quantum light, assuming no which-path information is encoded in the state of the electron, we obtain the photon state by projecting the full state over the desired energy state |ℓ*ₙ*〉, which returns |*ψ*〉 *= p*_{{*ℓ*ₙ}}|*ψ_{ℓ}*〉 *⊗* |{ℓ*ₙ*}〉, where *p*_{{*ℓ*ₙ}} is the probability of detecting an electron with said energy and |*ψ*_{ℓ}〉 is the light state.

### ACKNOWLEDGMENTS

This work was supported by European Research Council (Grant No. 101141220-QUEFES).

### References

[1] B. P. Abbott et al. (LIGO Scientific Collaboration and Virgo Collaboration), Phys. Rev. Lett. 116, 061102 (2016).
[2] P. J. Dowling, Contemp. Phys. 49, 125 (2008).
[3] A. N. Boto, P. Kok, D. S. Abrams, S. L. Braunstein, C. P. Williams, and J. P. Dowling, Phys. Rev. Lett. 85, 2733 (2000).
[4] J. G. Rarity, P. R. Tapster, E. Jakeman, T. Larchuk, R. A. Campos, M. C. Teich, and B. E. A. Saleh, Phys. Rev. Lett. 65, 1348 (1990).
[5] M. Mitchell, J. Lundeen, and A. Steinberg, Nature 429, 161 (2004).
[6] I. Afek, O. Ambar, and Y. Silberberg, Science 328, 879 (2010).
[7] P. Walther, J. W. Pan, M. Aspelmeyer, R. Ursin, S. Gas-paroni, and A. Zeilinger, Nature 429, 158 (2004).
[8] K. J. Resch, K. L. Pregnell, R. Prevedel, A. Gilchrist, G. J. Pryde, J. L. O'Brien, and A. G. White, Phys. Rev. Lett. 98, 223601 (2007).
[9] Y. A. Chen, X. H. Bao, Z. S. Yuan, S. Chan, B. Zhao, and J. W. Pan, Phys. Rev. Lett. 104, 043601 (2010).
[10] V. Di Giulio and F. J. Garcia de Abajo, Nanophotonics 11, 4659 (2022).
[11] V. Di Giulio, E. Akerboom, A. Polman, and F. J. Garcia de Abajo, ACS Nano 18, 14255 (2024).
[12] G. Arend, G. Huang, A. Feist, Y. Yang, J.-W. Henke, Z. Qiu, H. Jeng, A. S. Raja, R. Haindl, R. N. Wang, T. J. Kippenberg, and C. Ropers, (2024).
[13] F. J. Garcia de Abajo and A. Howie, Phys. Rev. Lett. 80, 5180 (1998).

## Claims

1. A system (100, 101, 102) for quantum sensing and metrology with free electrons, including one or more subsystems, each subsystem comprising:
an electron source (2) configured to provide an incident beam of electrons;
at least one optical waveguide (1) and at least one corresponding gate element (5) of the at least one optical waveguide (1), respectively;
the at least one optical waveguide (1) exhibiting respective electromagnetic modes confined within the waveguide (1);
one or more electron beam collimation and focusing elements (9) configured to collimate and focus the beam of electrons and to control a trajectory of the collimated and focused beam of electrons such that a distance between at least parts of the trajectory of the electron beam and the waveguide (1) is smaller than a penetration length of the confined electromagnetic modes of the waveguide (1) into the vacuum;
wherein the at least one gate element (5) is configured to generate an electric field according to a predetermined potential difference between the at least one gate element (5) and the at least one optical waveguide (1) the potential difference being between the at least one gate element (5) and the surface of the corresponding at least one optical waveguide (1), and to control a distance between the trajectory of the electron beam and the at least one optical waveguide (1) as being larger than or equal to a predetermined minimum distance;
wherein the predetermined minimum distance is smaller than the penetration length of the confined electromagnetic modes of the waveguide (1) into the vacuum;
wherein the at least one optical waveguide (1) is configured to interact with the electron beam in that the at least one optical waveguide (1) is configured to generate a plurality of waveguided photons when the beam of electrons travels along the parts of the trajectory of the beam of electrons being closer to the waveguide (1) than the penetration length of the confined electromagnetic modes of the waveguide (1) into the vacuum, wherein the plurality of photons is to be waveguided within the optical waveguide (1);
at least one electron detector (7, 7', 7") configured to measure an intensity of the beam of electrons after having interacted with the waveguide (1) to detect the plurality of photons waveguided by the waveguide (1).

2. The system according to claim 1, wherein the electron source (2) is a free-electron source.

3. The system according to any one of claims 1 to 2, comprising more than one optical waveguide (1) wherein the photons generated by each of the more than one optical waveguides (1) are phase-matched with respect to the incident electron beam.

4. The system according to any one of claims 1 to 3, wherein at least one of the optical waveguides (1) can have external light injected into the waveguide from an external light source, the external light giving rise to respective excited electromagnetic modes confined within the waveguide (1), and the at least one of the optical waveguides (1) having the external light is configured to interact with the electron beam.

5. The system according to any one of claims 1 to 4, wherein the electron detector (7, 7', 7") includes an electron spectrometer configured to measure a current of the incident electron beam as a function of the energy of the electron beam.

6. The system according to claim 5, wherein the system further includes a monochromator configured to monochromatize the energy of the electron beam before interacting with the at least one waveguide (1) and before entering the electron spectrometer.

7. The system according to any one of claims 5 to 6, further including one or more lateral electron beam shaping elements (11) such as bi-prisms and/or beam splitters (13.1, 13.2, 13.3, 13.4, 13.3', 13.4"), wherein at least one of the one or more beam shaping elements (11) is configured to split the electron beam into two separate paths of electron beams of a predefined amplitude ratio.

8. The system according to claim 7, wherein the predefined amplitude ratio is 50% / 50%.

9. The system according to claims 7 or 8, wherein the at least one of the one or more beam shaping elements (11) are configured such that the two separate paths of electron beams interact one after another with only a single waveguide (1).

10. The system according to claims 7 or 8, wherein the at least one of the one or more beam shaping elements (11) is configured such that only one of the two separate paths of electron beams interacts with a single waveguide (1) two or more times.

11. The system according to claims 7 or 8, wherein the system includes at least two optical waveguides (1), wherein the at least one of the one or more beam shaping elements (11) is configured such that each of the two separate paths of electron beams interacts with a different optical waveguide (1), respectively.

12. The system according to any one of claims 7, 8 or 11, wherein another one of the one or more beam shaping elements (11) is configured to recombine the two separate paths of electron beams after at least one of the two separate paths of electron beams has interacted at least once with the one or more waveguides (1), in order to erase distinguishability of the two separate paths of electron beams.

13. The system according to claim 12, wherein the electron detector (7, 7', 7") is further configured to measure an intensity of the beam of electrons after having interacted with the waveguide (1), in order to herald generated states of light of the photons emitted from the waveguide (1), such as NOON states.

14. The system according to claim 13, comprising two subsystems, wherein the electron source (2) of the second subsystem is configured to configured to provide a second incident beam of electrons, wherein the second subsystem includes one or more second lateral electron beam shaping elements such as bi-prisms and/or beam splitters, wherein the at least one of the one or more beam shaping elements is configured to split the second electron beam into two separate paths of second electron beams of a predefined amplitude ratio; wherein at least one of the two separate paths of second electron beams is configured to absorb the heralded states of light of the photons emitted from the waveguide (1) of the first subsystem.

15. A method (200) for quantum sensing and metrology with free electrons according to the system of any one of claims 1 to 14, the method comprising:
providing (S201) an incident beam of electrons;
collimating and focusing (S203) the beam of electrons and controlling the collimated and focused beam of electrons such that a trajectory of the collimated and focused beam of electrons such that a distance between at least parts of the trajectory of the electron beam and the waveguide (1) is smaller than a penetration length of the confined electromagnetic modes of the waveguide (1) into the vacuum;
generating (S205) an electric field according to a predetermined potential difference between the at least one gate element (5) and the at least one optical waveguide (1) the potential difference being between the at least one gate element (5) and the surface of the corresponding at least one optical waveguide (1), and to control a distance between the trajectory of the electron beam and the at least one optical waveguide (1) as being larger than or equal to a predetermined minimum distance;
wherein the predetermined minimum distance is smaller than the penetration length of the confined electromagnetic modes of the waveguide (1) into the vacuum;
interacting (S207) with the electron beam in that the at least one optical waveguide (1) is configured generate a plurality of photons when the beam of electrons travels along the parts of the trajectory of the beam of electrons being closer to the waveguide (1) than the penetration length of the confined electromagnetic modes of the waveguide (1) into the vacuum, wherein the plurality of photons is to be waveguided within the optical waveguide (1)
measuring (S209) an intensity of the beam of electrons after having interacted with the waveguide (1) to detect the plurality of photons waveguided by the waveguide (1).
